# EUROPÄISCHE PATENTSCHRIFT

(11) **EP 2 470 684 B1**
(45) Veröffentlichungstag und Bekanntmachung des Hinweises auf die Patenterteilung: **19.10.2016**
(21) Anmeldenummer: 10740629.0
(22) Anmeldetag: 04.08.2010
(51) Int. Cl.: C23C 16/44, C30B 25/14

(54) **CVD-VERFAHREN UND CVD-REAKTOR**
CVD METHOD AND CVD REACTOR
PROCÉDÉ CVD ET RÉACTEUR CVD

(30) Priorität: 25.08.2009 DE 102009043848
(43) Veröffentlichungstag der Anmeldung: 04.07.2012
(73) Patentinhaber: Aixtron SE, 52134 Herzogenrath (DE)
(72) Erfinder: STRAUCH, Gerhard, Karl, 52072 Aachen (DE)
(74) Vertreter: Grundmann, Dirk
(86) Internationale Anmeldenummer: PCT/EP2010/061360
(87) Internationale Veröffentlichungsnummer: WO 2011/023512

(56) Entgegenhaltungen:
- WO-A2-01/46498
- WO-A2-2008/130448
- JP-A- 59 223 294
- US-A- 4 503 807
- US-A- 5 578 521
- US-A1- 2004 237 894

## Beschreibung

Die Erfindung betrifft ein Verfahren zum Abscheiden von insbesondere aus mehreren Komponenten bestehenden Halbleiterschichten auf ein oder mehreren Substraten, die auf einem Suszeptor aufliegen, der eine von einer Heizeinrichtung auf eine Prozesstemperatur beheizte Wandung einer Prozesskammer ausbildet, wobei durch Strömungskanäle eines Gaseinlassorganes von einem Gasmischsystem bereitgestellte Prozessgase zusammen mit einem Trägergas in die Prozesskammer eingeleitet werden, welches Trägergas die Prozesskammer im Wesentlichen parallel zum Suszeptor durchströmt, wobei sich die Prozessgase zumindest an der Oberfläche des beheizten Substrates pyrolytisch in Zerlegungsprodukten zerlegen und die Zerlegungsprodukte auf der Substratoberfläche und auf der Oberfläche eines stromabwärts mit einem Abstand zum stromabwärtigen Rand des Suszeptors angeordneten Gasauslassorganes zumindest bereichsweise eine Beschichtung bildend aufwachsen, wobei ein erster Prozessschritt bei einer ersten Prozesstemperatur durchgeführt wird und danach ohne zwischenzeitiges Reinigen oder Austauschen des mit aufgewachsenen Zerlegungsprodukten belegten Gaseinlassorganes ein zweiter Prozessschritt bei einer zweiten Prozesstemperatur durchgeführt wird, welche höher ist als die erste Prozesstemperatur.

Die Erfindung betrifft darüber hinaus auch eine Vorrichtung zum Abscheiden von insbesondere aus mehreren Komponenten bestehenden Halbleiterschichten auf ein oder mehreren Substraten, mit einem Suszeptor, auf dem das Substrat aufliegt und der eine von einer Heizeinrichtung auf eine Prozesstemperatur beheizte Wandung einer Prozesskammer ausbildet, mit einem mittels Gaszuleitungen mit einem Gasmischsystem verbunden Gaseinlassorgan, wobei durch Strömungskanäle des Gaseinlassorganes vom Gasmischsystem bereitgestellte Prozessgase zusammen mit einem Trägergas in die Prozesskammer einleitbar sind und die Strömungskanäle derart in der Prozesskammer angeordnet sind, dass das Trägergas die Prozesskammer im Wesentlichen parallel zum Suszeptor durchströmt, wobei der Suszeptor und ein stromabwärts des Suszeptors mit einem Abstand zum stromabwärtigen Rand des Suszeptors angeordnetes Gasauslassorgan von der Heizeinrichtung direkt oder indirekt derart aufheizbar sind, dass sich die Prozessgase zumindest an der Oberfläche des Substrates in Zerlegungsprodukten zerlegen und die Zerlegungsprodukten auf den heißen Oberflächen des Substrates und des Gasauslassorganes pyrolytisch zumindest bereichsweise eine Beschichtung bildend aufwachsen.

Eine gattungsgemäße Vorrichtung wird in der DE 100 43 600 A1, der EP 1 060 301 B1 und der EP 1240 366 B1 beschrieben. Die Vorrichtungen besitzen ein Reaktorgehäuse, das gegenüber der Umgebung gasdicht geschlossen ist. Innerhalb des Reaktorgehäuses befindet sich eine Prozesskammer. Diese besitzt die Form eines Kreiszylinders. Der kreisscheibenförmige Boden der Prozesskammer wird von einem mehrteiligen, aus Graphit bestehenden Suszeptor ausgebildet, welcher auf seiner zur Prozesskammer hinweisenden Seite eine Vielzahl von um das Zentrum angeordnete Aussparungen aufweist, in denen kreisscheibenförmige Substrathalter einliegen, auf deren Oberfläche jeweils ein zu beschichtendes Substrat aufliegt. Die Substrathalter werden von einem Gasstrom auf einem Gaspolster lagernd drehangetrieben. Der auf einer zentralen Säule ruhende Suszeptor kann ebenfalls um die Symmetrieachse der Prozesskammer gedreht werden. Oberhalb des sich in einer Horizontalebene erstreckenden Suszeptors befindet sich eine Prozesskammerdecke, die ebenfalls aus Graphit gefertigt ist. Im Zentrum der Prozesskammerdecke befindet sich ein Gaseinlassorgan, welches mit Zuleitungen mit einem Gasmischsystem verbunden ist, von welchem Austrittskanäle des Gaseinlassorganes mit einem Trägergas und mit dem Trägergas transportierten Prozessgasen gespeist wird. Bei den Prozessgasen handelt es sich einerseits um ein Metallorganikum, bspw. TMGa, TMIn oder TMA1. Das andere Prozessgas ist ein Hydrid, bspw. Arsin, Phosphin oder Ammoniak. Mit diesen Prozessgasen sollen auf den Substratoberflächen Halbleiterschichten abgeschieden werden, die aus Ga, In, A1, P, As und N bestehen können. Mit der Vorrichtung können nicht nur III-V-Halbleiterschichten, sondern durch geeignete Wahl der Ausgangsstoffe auch II-VI-Halbleiterschichten abgeschieden werden. Ferner ist es möglich, durch Zugabe geeigneter weiterer hochverdünnter Ausgangsstoffe die abgeschiedenen Halbleiterschichten zu dotieren.

Die zusammen mit dem Trägergas in das Zentrum der Prozesskammer eingeleiteten Prozessgase durchströmen die Prozesskammer in horizontaler Richtung parallel zur Prozesskammerdecke und zum Prozesskammerboden. Der Prozesskammerboden und ggf. auch die Prozesskammerdecke werden auf eine Prozesstemperatur geheizt. Dies erfolgt über eine RF-Heizung. Hierzu befinden sich unterhalb des Suszeptors Windungen einer wassergekühlten Heizspirale. Die Prozessgase zerlegen sich an den heißen Oberflächen und insbesondere an der heißen Substratoberfläche pyrolytisch in Zerlegungsprodukte. Der Prozess wird so geführt, dass das Wachstum der Halbleiterschichten auf dem Substrat im kinetisch kontrollierten Temperaturbereich stattfindet, da in diesem Temperaturbereich die höchste Kristallqualität erzielbar ist. Bei dem Prozess ist nicht zu vermeiden, dass sich auch auf den die Substrate umgebenden Oberflächenbereichen des Suszeptors, an der Unterseite der Prozesskammerdecke und an einem die stromabwärtige Prozesskammerwandung bildenden Gasauslassorgan eine parasitäre Beschichtung aufwächst.

Die thermischen Behandlungsprozesse, die in der in Rede stehenden Vorrichtung stattfinden, erfordern unterschiedlich hohe Prozesstemperaturen. Bei einem gattungsgemäßen Verfahren wird in einem ersten Prozessschritt eine erste Schicht eines ersten Materials auf das Substrat abgeschieden. Dies erfolgt bei einer niedrigen Prozesstemperatur, die bspw. im Bereich von 500°C bis 800°C liegen kann. Nach einem oder mehreren Spülschritten und ggf. auch weiteren Zwischenschritten wird ein zweiter Prozessschritt durchgeführt, bei dem die Prozesstemperatur wesentlich höher ist, bspw. mindestens 1.000°C beträgt. Bei diesem Prozessschritt wird eine Schicht aus einem zweiten Material auf die erste Schicht bzw. auf weitere Zwischenschichten abgeschieden. Das im ersten Prozessschritt teilweise mit Zerlegungsprodukten belegte Gasauslassorgan wurde in der Zwischenzeit zwischen erstem und zweitem Prozessschritt nicht gereinigt oder ausgetauscht. Bei einer anschließenden Analyse der im zweiten Prozessschritt abgeschiedenen Schicht fanden sich Spuren der Zerlegungsprodukte der im ersten Prozessschritt in die Prozesskammer eingeleiteten Prozessgase.

Mit der gattungsgemäßen Vorrichtung kann darüber hinaus auch ein Abscheideverfahren ausgeübt werden, welches mit einem Prozessschritt beginnt, der mit einer sehr hohen Prozesstemperatur durchgeführt wird, bspw. 1.600°C. Bei diesem Prozessschritt kann es sich um einen Temper-Schritt handeln. Wurde in einem vorherigen Abscheideprozess auf zwischenzeitig ausgetauschten Substraten ein Wachstumsschritt bei einer niedrigeren Temperatur durchgeführt, war es zu einer parasitären Belegung des Gasauslassorganes gekommen. Wurde beim Substratwechsel das Gasauslassorgan nicht ausgetauscht, liegt beim Temper-Prozess beim folgenden Beschichtungsvorgang ein kontaminiertes Gasauslassorgan vor. Auch bei dieser Prozessführung folgt einem ersten Prozessschritt bei einer niedrigen Temperatur, bei dem ein Schichtwachstum stattfindet, ein zweiter Prozessschritt bei einer hohen Prozesstemperatur. Auch hier wurde bei einer nachfolgenden Analyse der abgeschiedenen Schichten festgestellt, dass Zerlegungsprodukte der früheren Prozessschritte in später abgeschiedenen Schichten eingebaut wurden.

Zum Stand der Technik gehört auch die EP 0 449 821, die einen CVD-Reaktor beschreibt, bei dem ein Suszeptor, auf dem zu beschichtende Substrate liegen, von unten beheizt wird. Die nach oben hin von einem Deckel verschlossene Prozesskammer wird in Horizontalrichtung von Prozessgas durchströmt. Um gasaustrittsseitig eine Re-Zirkulation des Reaktionsgases zu verhindern sind Stabilisatorflügel vorgesehen, die enge Kanäle ausbilden, durch die das Gas strömt.

Die EP 0 252 667 beschreibt einen CVD-Reaktor mit einer Prozesskammer, deren Boden ein drehbarer Suszeptor ausbildet, auf dem ein Substrat aufliegt. Durch die Prozesskammer strömt in horizontaler Richtung ein Prozessgas, welches durch Einleiten eines zusätzlichen Inertgases von oben in Richtung auf den Suszeptor gedrängt wird. Hierdurch soll eine laminare Gasströmung über das zu beschichtende Substrat eingestellt werden.

Die US 5,891,251 beschreibt einen CVD-Reaktor mit einer von unten beheizten Prozesskammer, die horizontal vom Prozessgas durchströmt wird. Auch hier sind ergänzende Inertgasströme vorgesehen, um das Strömungsbild des Prozessgases zu beeinflussen.

Die US 5,951,772 beschreibt einen CVD-Reaktor mit einer Prozesskammer, deren Boden ein Suszeptor ausbildet, der von unten her mit einer Lampe beheizt wird. Oberhalb des Suszeptors befindet sich ein duschkopfartiges Gaseinlassorgan. Die Wände des Reaktorgehäuses sind beheizt. Auf einem Niveau unterhalb des Sus-zeptors befindet sich ein Gasauslass, um Prozessgas aus der Prozesskammer mit einer Pumpe abzusaugen.

Die US 2002/0000196 A1 beschreibt einen CVD-Reaktor mit einer Prozesskammer mit einem duschkopfartigen Gaseinlassorgan und einem zu beschichtenden Substrat, welches von unten beheizt wird.

Die US 2003/0136365 A1 zeigt ein Gasauslassrohr. Es besitzt einen mit einer Heiz-manschette versehenes Innenrohr.

Die US 2005/0011441 A1 beschreibt einen CVD-Reaktor mit einem Suszeptor, auf dem ein zu beschichtendes Substrat aufliegt, welches von unten her beheizt wird. Es ist ein Gasauslass vorgesehen, der auf einem tieferen Niveau liegt, als der Suszeptor.

Die US 2006/0225649 A1 beschreibt einen CVD-Reaktor mit einem duschkopfartigen Gaseinlassorgan und einem den Boden einer Prozesskammer ausbildenden Suszeptor, auf dem das Substrat aufliegt. Es ist ein Gasauslassring vorgesehen, der den Suszeptor mit einem Abstand unter Belassen eines Spaltes umgibt.
Die US 2009/0044699 A1 befasst sich mit dem Problem der Polymerbildung in einem Gasauslasssystem. Mit Hilfe einer dort angeordneten Heizung sollen die chemischen Bindungen der Polymere aufgebrochen werden.

Die US 2009/0114155 A1 befasst sich mit einem CVD-Reaktor und einer im Gasaus-lassstrom angeordneten Kühlfalle, die ausgeheizt werden kann.
Die JP 08078338 A beschreibt einen CVD-Reaktor, bei dem das Substrat in einem schwebenden Zustand gehalten wird, so dass es von beiden Seiten beschichtet werden kann.
Die JP 10306375 A beschreibt ein besonderes Gasmischsystem für einen CVD-Reaktor, dessen Ventilanordnung so gewählt ist, dass Druckfluktuationen innerhalb der Prozesskammer reduziert werden.

WO2008/130448 A2 offenbart eine Vorrichtung zum Abscheiden von Halbleiterschichten auf ein Substrat, mit einem von einem kontrolliert aufheizbaren Gasauslassorgan beabstandeten Suszeptor, einer Heizeinrichtung und einem mit einem Gasmischsystem verbunden Gaseinlassorgan.

Der Erfindung liegt die Aufgabe zugrunde, Maßnahmen anzugeben, mit denen ohne zwischenzeitigen Austausch oder ohne zwischenzeitiges Reinigen des Gasauslassorganes kontaminationsfreie Schichten in aufeinander abfolgenden Prozessschritten abscheidbar sind.

Gelöst wird die Aufgabe durch die in den Ansprüchen angegebene Erfindung. Die Unteransprüche stellen vorteilhafte Weiterbildungen der nebengeordneten Ansprüche 1 und 6 dar. Darüber hinaus bilden die Unteransprüche aber auch eigenständige Lösungen der Aufgabe und sind miteinander beliebig kombinierbar.

Der Erfindung liegt die im Wege von Experimenten und Modellrechnungen gewonnene Erkenntnis zugrunde, dass die beobachtete Schichtkontamination ihren Ursprung in der Belegung des Gasauslassorganes hat. Hierzu wurden in Untersuchungsreihen die Kontamination unter Verwendung von Testschichten, die extrem hoch dotiert waren, untersucht. Das Maß der Kontamination wurde am Interface zwischen Substrat und einer zweiten Schicht gegenüber einem Interface zwischen Substrat und einer ersten Schicht objektiviert. Bei den Untersuchungen wurde herausgefunden, dass sich die Oberflächentemperatur des Gasauslassorganes signifikant mit ändert. Diese Beobachtung wurde auch an solchen Vorrichtungen gemacht, wie sie von der EP 1 240 366 B1 beschrieben werden, bei denen das Gasauslassorgan zum Wechseln des Substrates absenkbar ist und hierzu einen Abstand zum Suszeptor aufweist. Einen derartig geringfügigen Abstand zwischen Suszeptor und Gasauslassorgan zeigt auch die Fig. 1 der EP 1 060 301 B1. In den in Rede stehenden Strömungsreaktoren wird die Prozesskammer in Horizontalrichtung von den Prozessgasen durchströmt. Zwischen Suszeptor und Gasauslassorgan bildet sich eine Strömungsbarriere. Die Zerlegungsprodukte, die bei der niedrigeren Prozesstemperatur parasitär auf der Oberfläche des Gasauslassorganes aufwachsen, haben die Tendenz, in dem zweiten Prozessschritt, in dem bisher nicht nur der Suszeptor, sondern auch das Gasauslassorgan auf eine deutlich höhere Temperatur aufgeheizt werden, von der Oberfläche des Gasauslassorganes abzudampfen. Die so in die Gasphase gelangten Komponenten diffundieren in alle Richtungen, also auch gegen den Gasstrom. Es wurde erkannt, dass diese Gegenstromdiffusion verantwortlich für die unerwünschte Kontamination der im zweiten Prozessschritt abgeschiedenen Schichten oder später abgeschiedenen Schichten ist. Selbst bei einem lediglich bei einer hohen Temperatur durchgeführten Temper-Schritt kommt es zu einer Kontamination der getemperten Substratoberfläche, da die bei den hohen Prozesstemperaturen vom Gasauslassorgan abdampfenden Zerlegungsprodukte in die Prozesskammer bis hin zum Substrat diffundieren und sich dort an der Oberfläche anlagern.

Die erfindungsgemäße Maßnahme, um diesem Missstand zu begegnen, liegt darin, dass bei der Konstruktion der Vorrichtung der Abstand zwischen dem stromabwärtigen Rand des Suszeptors und dem Gasauslassorgan groß genug ausgelegt wird, um zu verhindern, dass von der Beschichtung des Gasauslassorganes abdampfende Zerlegungsprodukte, Fragmente oder Konglomerate davon durch Gegenstromdiffusion oder Rezirkulation zum Substrat gelangen. Des Weiteren betrifft die erfindungsgemäße Maßnahme eine besondere Temperierung des Gasauslassorganes. Diese erfolgt derart, dass dessen Oberflächentemperaturen bei den Prozessschritten mit verschiedenen Prozesstemperaturen nur unwesentlich verschieden voneinander sind. In entsprechender Weise wird das Verfahren so durchgeführt, dass die Bedingungen in der Gasphase, Temperatur, Druck oder dergleichen so eingestellt sind, dass der Abstand zwischen dem stromabwärtigen Rand des Suszeptors und des Gasauslassorganes ausreichend groß ist, um zu verhindern, dass von der Beschichtung des Gasauslassorganes bei der zweiten Prozesstemperatur abdampfende Zerlegungsprodukte, Fragmente oder Konglomerate davon durch Gegenstromdiffusion oder Rezirkulation zum Substrat zurückgelangen. Dabei kann alternativ oder optional zusätzlich das Gasauslassorgan während der beiden Prozessschritte derart temperiert werden, dass dessen Oberflächentemperaturen bei beiden Prozessschritten nur unwesentlich verschieden voneinander sind. Dieser Temperaturbereich kann durchaus 100°C und mehr betragen. Er hängt von den chemischen bzw. physikalischen Eigenschaften der Belegung des Gasauslassorganes ab. Optimal ist es, wenn die dem Suszeptor nächstliegende Oberfläche einen Abstand vom Suszeptor besitzt, der der dreifachen Diffusionslänge entspricht. Es handelt sich hierbei um die von der Strömungsgeschwindigkeit abhängende Gegenstromdiffusionslänge. Diese Rückdiffusionslänge ist definiert durch die Strecke, innerhalb welcher die Gasphasenkonzentration der abgedampften Zerlegungsprodukte auf 1/e abgesunken ist. Die Temperierung des Gasauslassorganes erfolgt über ein oder mehrere unterhalb des Suszeptors angeordnete Heizspiralen und insbesondere von einer äußeren Heizwindung. Damit wird das Gasauslassorgan separat aktiv beheizt. Hierzu befindet sie sich in unmittelbarer Nachbarschaft des ringförmig die Prozesskammer umgebenden Gasauslassorganes. Das Gasauslassorgan ist aus einem elektrisch leitenden Material gefertigt, so dass es mit Hilfe von Wirbelströmen aufgeheizt werden kann, die von der RF-Spule erzeugt werden. In einer bevorzugten Ausgestaltung ist vorgesehen, dass das Gasauslassorgan vertikal unterhalb des sich in der Horizontalebene erstreckenden Suszeptors angeordnet ist. Durch die Positionierung und die aktive Beheizung des Gasauslass-organes kann dessen Oberfläche im Wesentlichen unabhängig von der Prozessführung temperiert werden. Die Oberflächentemperatur des Gasauslassorganes schwankt somit deutlich geringer, als die Oberflächentemperatur des Suszeptors. Die Oberflächentemperatur des Suszeptors kann bei verschiedenen Prozessschritten durchaus um mehr als 500°C verschieden sein. Das Gasauslassorgan wird derart aktiv beheizt, dass es bei einer derartigen Temperaturvariation nur zu einer Temperaturvariation von maximal 100°C kommt. In einem Prozess mit einer homogenen Gasphasenreaktion, bei der die Zerlegungsprodukte nicht nur durch pyrolytische Zerlegung an der Oberfläche entstehen, sondern auch Gasphasenreaktionen stattfinden, muss das Gasauslassorgan eine Temperatur besitzen, die oberhalb der Adduktbildungstemperatur liegt. Dies gilt auch für die Prozesskammerdecke, die bei solchen Prozessen aktiv beheizt wird. Bei derartigen Prozessen zerlegen sich insbesondere die metallorganischen Komponenten über mehrere Zwischenschritte in elementares Metall, bspw. Gallium, Indium oder Aluminium. Bei den üblichen Prozesstemperaturen sind diese Metalle wegen ihres niedrigen Dampfdrucks aber nicht flüchtig. Es kommt daher in der Gasphase zu einer Keimbildung. Diese Nukleation ist Ursache für eine Adduktbildung. Letztere soll verhindert werden. Hierzu muss sichergestellt werden, dass es innerhalb der Prozesskammer zu keinen kalten Zonen kommt. Der aus Graphit bestehende Suszeptor lagert auf einer Stützplatte, die aus Quarz besteht. Der Rand dieser Stützplatte lagert auf dem stromabwärtigen Rand des Suszeptors. An den Rand der Stützplatte schließt sich unmittelbar der ebenfalls aus Graphit gefertigte Gasauslassring an. Dieser besitzt etwa auf Höhe der Quarzplatte mündende Öffnungen, durch die das Trägergas in ein Sammel-volumen des Gasauslassorganes einströmen kann. Das Gasauslassvolumen ist mit einem Austrittskanal verbunden, welcher mit einer Vakuumpumpe verbunden ist. Bei dem erfindungsgemäßen CVD-Reaktor können Gaseinlassorgane verwendet werden, wie sie aus dem Stand der Technik grundsätzlich bekannt sind. Beispielsweise kann es sich um ein Gaseinlassorgan handeln, welches im Zentrum einer kreisrunden Prozesskammer angeordnet ist. Dieses Gaseinlassorgan besitzt zumindest zwei voneinander getrennte Strömungskanäle, durch die ein Metallorganikum und ein Hydrid in die Prozesskammer gelangen. Diese Strömungskanäle sind über Zuleitungen, Massenflussregler und Ventile mit Vorratsbehältern verbunden, in denen das Trägergas und die Prozessgase bevorratet werden. Als Trägergas kommt Wasserstoff, Stickstoff oder ein Edelgas in Betracht. Alternativ zu einem zentrischen Gaseinlassorgan kann auch ein Gaseinlassorgan in Form eines Showerheads verwendet werden, wie er bspw. in der EP 0 687 749 B1 beschrieben wird. Dieser bildet die Prozesskam-merdecke aus und besitzt eine Vielzahl von über der gesamten Fläche gleichmäßig verteilter Austrittsöffnungen, aus denen die Prozessgase in die Prozesskammer eintreten können. Die verschiedenen Prozessgase können dabei durch verschiedene Gasaustrittsöffnungen in die Prozesskammer eintreten. Auch hier wird ein Gasstrom erzeugt, der sich im Wesentlichen parallel zur Oberfläche des Suszeptors bewegt.

Ausführungsbeispiele der Erfindung werden nachfolgend anhand beigefügter Zeichnungen erläutert. Es zeigen:
- Fig. 1: einen halben Querschnitt durch ein erstes Ausführungsbeispiel einer Vorrichtung,

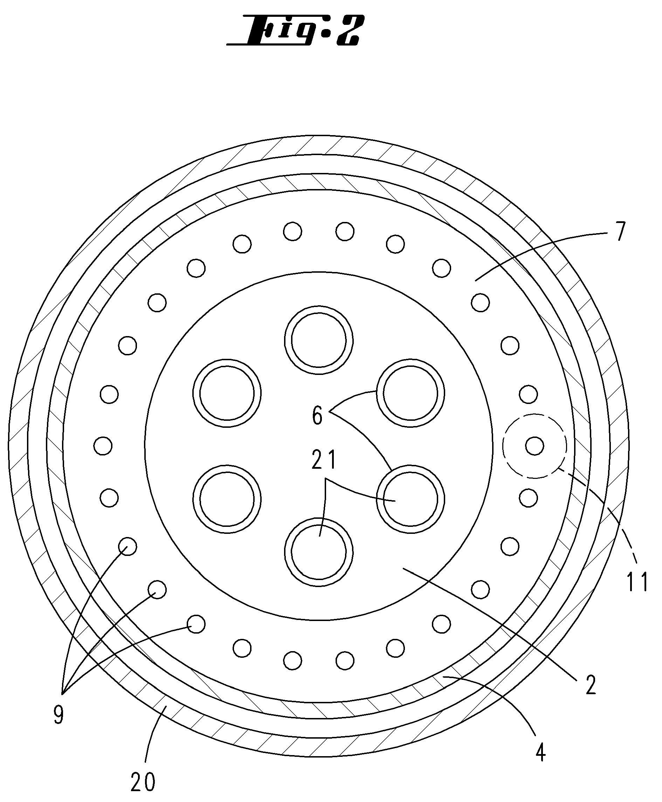

- Fig. 2: einen Schnitt gemäß der Linie II - II in Fig. 1,
- Fig. 3: eine Darstellung gemäß Fig. 1 eines zweiten Ausführungsbeispiels mit einem anders gestalteten Gaseinlassorgan und
- Fig. 4: ein weiteres Ausführungsbeispiel, in welchem grobschematisch die wesentlichen Bestandteile der Prozesskammer dargestellt sind und zusätzlich ein Gasmischsystem.

Das für die Versorgung einer erfindungsgemäßen Vorrichtung geeignete Gasmischsystem 22 besitzt einen Vorratsbehälter 23 für ein Metallorganikum, einen Vorratsbehälter 24 für ein Trägergas und einen Vorratsbehälter 25 für ein Hydrid. Bei dem Metallorganikum kann es sich um TMGa, TMIn, TMAI oder dergleichen handeln. Bei dem Trägergas kann es sich um Wasserstoff, Stickstoff oder ein Edelgas handeln. Bei dem Hydrid kann es sich um AsH₃, PH₃ oder NH₃ handeln. Nicht dargestellt sind optionale weitere Vorratsbehälter zur Bevorratung weiterer Prozessgase und insbesondere von Dotierstoffen. Die Prozessgase und das Trägergas werden über Massenflussregler 26, denen Ventile vorgeschaltet sind, dosiert. Optimal erfolgt die Bereitstellung über ein nicht dargestelltes Vent/Run-System. Die Zuleitungen 27, 28 münden in das Gaseinlassorgan 8.

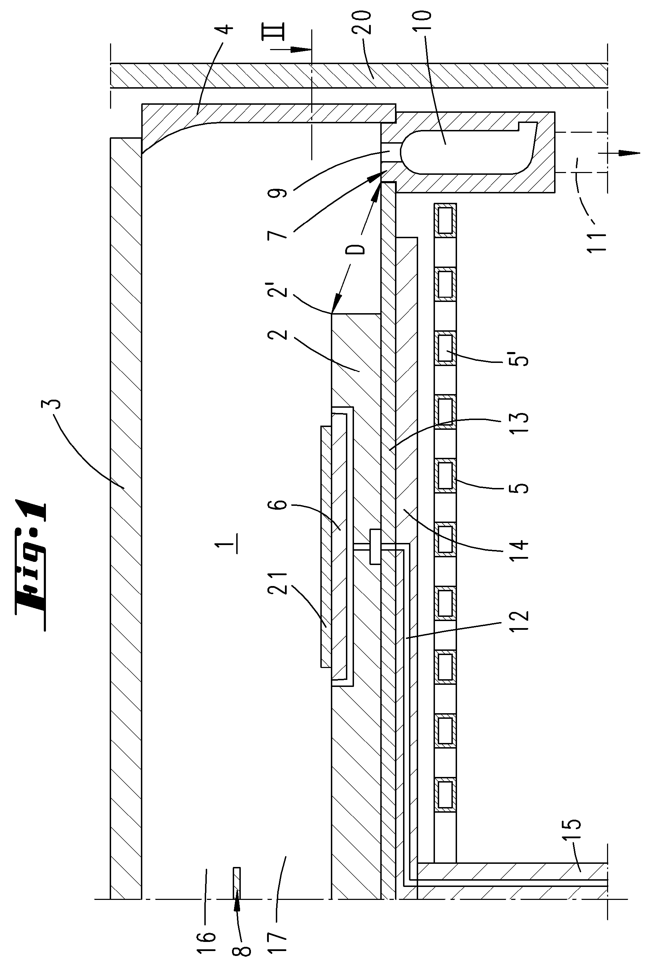

Bei dem in der Fig. 1 dargestellten Ausführungsbeispiel ist das Gaseinlassorgan 8 im Zentrum einer rotationssymmetrischen Prozesskammer 1 angeordnet. Der

Boden der Prozesskammer 1 wird von einem aus Graphit gefertigten Suszeptor 2 ausgebildet, der eine Vielzahl von Oberflächenaussparungen aufweist, in denen jeweils ein kreisförmiger Substrathalter 6 einliegt. Über eine Gaszuleitung 12 wird ein Stützgas über Düsen in die Aussparung eingebracht, so dass der Substrathalter 6 auf einem Gaspolster lagernd gedreht wird. Die einzelnen Substrathalter 6 umgeben das Zentrum der Prozesskammer 1 in einer kreisförmigen Anordnung.

Der Suszeptor 2 ruht auf einer Stützplatte 13 aus Quarz. Der stromabwärtige Rand 2' wird vom Randabschnitt der Stützplatte 13 in Radialrichtung überragt. Der eine Diffusionsbarriere ausbildende Randabschnitt der Quarzplatte 13 überragt den Rand 2' des Suszeptors 2 um einen Abstand D, der eine prozessrelevante Größe darstellt.

Die Quarzplatte 13 lagert auf einer Verteilerplatte 14, mittels welcher die Stützgase dem Suszeptor 2 zugeführt werden. Mit der Bezugsziffer 15 ist eine Säule dargestellt, die so ausgestaltet sein kann, dass der Suszeptor 2 um seine Achse drehangetrieben werden kann.

Unterhalb des Suszeptors 2 und unterhalb der Platten 13,14 ist eine spiralförmige RF-Heizspule 5 angeordnet. Der Spulenkörper ist ein Hohlkörper, der von einem Kühlmedium durchströmt wird.

Die radial äußerste Windung 5' der RF-Heizspirale 5, die ggf. gesondert mit Heizenergie versorgt werden kann, liegt in unmittelbarer Nachbarschaft zu einem Gasauslassorgan 7.

Das Gasauslassorgan 7 besteht aus einem ringförmigen Körper, der aus Molybdän oder bevorzugt aus Graphit gefertigt ist. Das Gasauslassorgan 7 schließt sich unmittelbar an den radial äußeren Rand der Quarzplatte 13 an. Das Gasauslassorgan 7 besitzt nach oben weisende Öffnungen 9, durch welche Gas aus der Prozesskammer 1 in ein Sammelvolumen 10 einströmen kann. Das Sammelvolumen 10 ist über einen Austrittskanal 11 mit einer Vakuumpumpe verbunden. Die gesamte vorbeschriebene Vorrichtung befindet sich innerhalb eines Reaktorgehäuses 20, mit welchem die Prozesskammer 1 gasdicht gegenüber der der Außenwelt abgeschirmt ist. Die obere Wandung der Prozesskammer 1 wird von einer ebenfalls aus Graphit bestehenden Prozesskammerdecke 3 ausgebildet. Letztere kann - wie im Stand der Technik, insbesondere der DE 100 43 600 A1 beschrieben - auch separat beheizt werden. Die seitliche Wandung der Prozesskammer 1 wird von einer ringförmigen Seitenwand 4 ausgebildet.

Das Gasauslassorgan 7 befindet sich stromabwärts beabstandet vom Suszeptor 2. Es ist in horizontaler Richtung beabstandet und liegt in vertikaler Richtung tiefer als der Suszeptor 2. Das Gasauslassorgan 7 kann mit einer ihm zugeordneten Heizeinrichtung 5' aktiv beheizt werden.

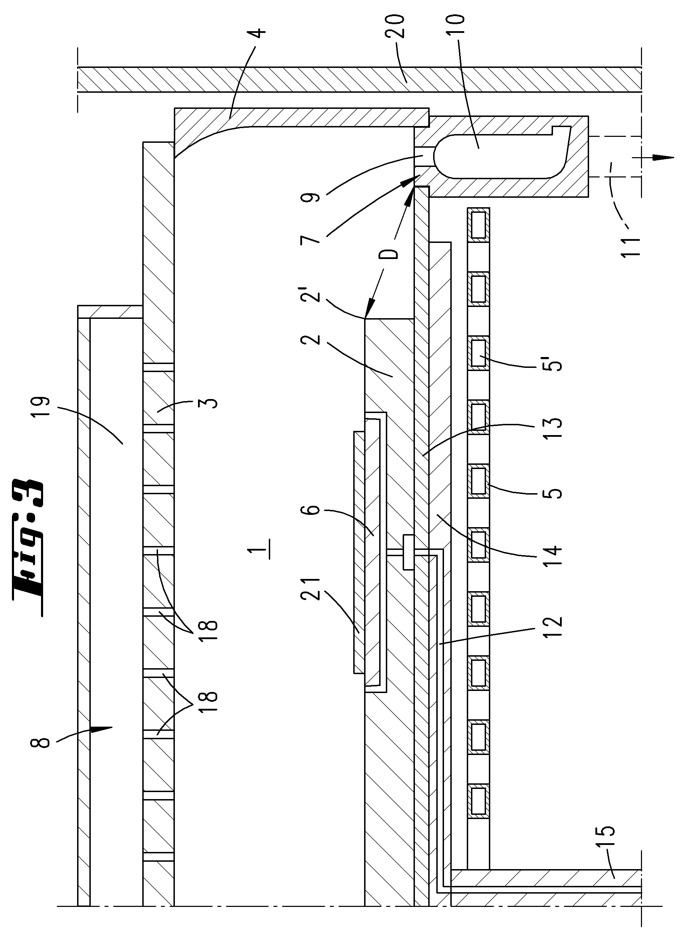

Das in der Fig. 3 dargestellte Ausführungsbeispiel unterscheidet sich von dem in der Fig. 1 dargestellten Ausführungsbeispiel im Wesentlichen durch die Ausgestaltung des Gaseinlassorganes 8. Das Gaseinlassorgan ist hier als Showerhead ausgebildet und besitzt eine Gestaltung, wie sie die EP 0 667 749 B1 beschreibt, nämlich eine Vielzahl an der Prozesskammerdecke 3 angeordnete Austrittsöffnungen 8 zum Eintritt des Prozessgases in die Prozesskammer 1. Oberhalb dieser Gasaustrittsöffnung 18 ist mit der Bezugsziffer 19 ein Gasverteilvolumen angedeutet. In der Fig. 3 ist nur ein einziges Gasverteilvolumen dargestellt. In bevorzugten Ausgestaltungen sind jedoch mehrere Gasverteilvolumina vorgesehen, wie sie bspw. von der EP 0 687 749 B1 beschrieben werden.

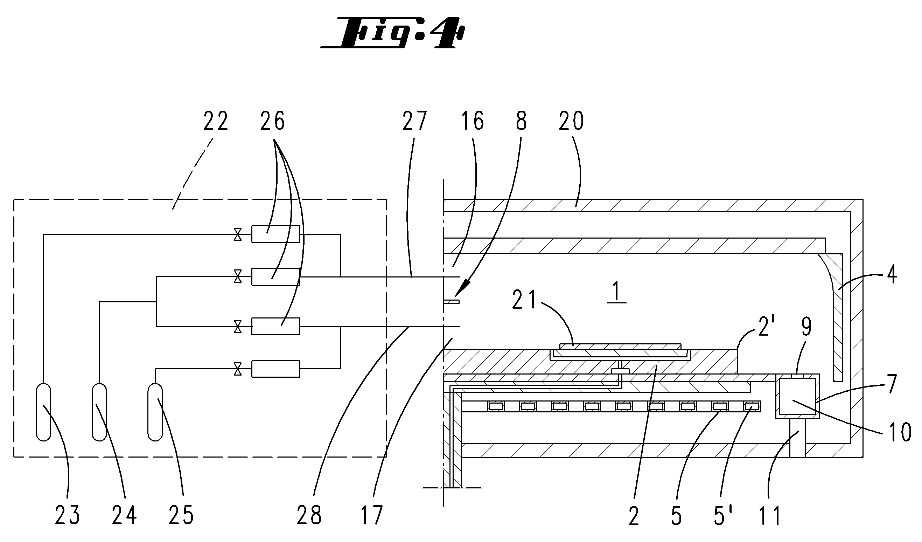

Bei dem in der Fig. 4 dargestellten Ausführungsbeispiel handelt es sich ebenfalls um einen Horizontalreaktor, bei dem die Öffnungen 9 des Gasauslassorganes 7 unterhalb des horizontalen Niveaus der das Substrat 21 tragenden Oberfläche des Suszeptors 2 liegen.

Bei dem in den genannten Vorrichtungen durchgeführten Verfahren werden mehrere Prozessschritte hintereinander durchgeführt, ohne dass zwischen den Prozessschritten das Gasauslassorgan gereinigt oder ausgetauscht wird. Es kommt mithin zumindest im ersten Prozessschritt zu einer Belegung des Gasauslassorganes 7 mit Zerlegungsprodukten der Prozessgase. Der erste Prozessschritt wird bei einer niedrigen Temperatur, bspw. bei einer Temperatur zwischen 500°C und 1.000°C durchgeführt. Bei diesem Prozessschritt wird bspw. durch die Einleitung eines Metallorganikums und eines Hydrides eine III-V-Halbleiterschicht auf dem Substrat abgeschieden. Aus solchen Zerlegungsprodukten wird auch eine parasitäre Beschichtung auf den Oberflächen des Gasauslassorganes 7 abgeschieden. Durch eine gesonderte Temperaturführung des Gasauslassorganes 7 wird dessen Temperatur in einem begrenzten Temperaturbereich gehalten. Der Totaldruck innerhalb der Prozesskammer liegt im Bereich zwischen 1 mbar und 1.000 mbar. Bevorzugt liegt der Totaldruck zwischen 20 mbar und 500 mbar.

Im Anschluss an diesen ersten Prozessschritt können weitere Zwischenschritte durchgeführt werden. Es können bei unterschiedlichen Prozesstemperaturen und unterschiedlichen Totaldrucken und unter der Verwendung von anderen Prozessgasen weitere Schichten auf die erste Schicht abgeschieden werden. Es ist auch möglich, vor einem erfindungsgemäßen zweiten Prozessschritt die bereits beschichteten Substrate aus der Prozesskammer zu entfernen und jungfräuliche Substrate in die Prozesskammer einzubringen. Der erfindungsgemäße zweite Prozessschritt unterscheidet sich vom erfindungsgemäßen ersten Prozessschritt im Wesentlichen durch seine Prozesstemperatur. Diese soll höher sein als die Prozesstemperatur im ersten Prozessschritt. Der zweite Prozessschritt kann bei Temperaturen zwischen 1.000°C und 1.600°C durchgeführt werden, so dass sich die beiden Prozesstemperaturen um mindestens 500°C unterscheiden. So kann der zweite Prozessschritt ein Beschichtungsprozess oder ein lediglicher Temper-Prozess sein.

Der oben erwähnte Abstand D zwischen dem stromabwärtigen Rand 2' des Suszeptors 2 und dem Gasauslassorgan 7 ist so gewählt, dass bei den Prozessparametern des zweiten Prozessschrittes, also bei der zweiten Prozesstemperatur, und bei dem Totaldruck beim zweiten Prozessschritt keine Rückdiffusion oder Rückzirkulation von der Beschichtung des Gasauslassorganes abdampfenden Zerlegungsprodukten, Fragmenten davon oder Konglomeraten davon zum Substrat 21 gelangen. Hierzu entspricht der Abstand D mindestens der dreifachen Rückdiffusionslänge der in Frage kommenden abgedampften Stoffe. Die Rückdiffusionslänge ist eine charakteristische Größe, die dem exponentiell abfallenden Verlauf der Konzentrationsverarmungskurve entnommen ist. Dabei wird durch den 90%-Punkt und den 10%-Punkt der Verarmungskurve eine Gerade gezogen. Der Schnittpunkt der Geraden mit der X-Achse, auf welcher der Abstand abgetragen wird, definiert die Diffusionslänge. Diese beträgt für das System Magnesium in Wasserstoff bei 400 mbar und einer Wandtemperatur von 600°C 15 mm. Der Minimalwert für den Abstand D liegt in diesem System dann bei 45 mm. Optimal ist es, hier einen Wert von 60 mm anzusetzen.

Mit der aktiven Beheizung des Gasauslassorganes 7 mittels der Heizeinrichtung 5' wird dessen Oberflächentemperatur darüber hinaus auf Werten gehalten, die maximal etwa 100°C höher liegen als dessen Oberflächentemperaturen beim ersten Prozessschritt. Zufolge dieser Maßnahme wird die Abdampfrate von Belegungen des Gasauslassorganes 7 zumindest minimiert bzw. nicht geändert.

Die Oberfläche der Stützplatte 13 im Abstandsbereich D ist so gewählt, dass sich dort nur eine minimale Abscheidung bildet.

## Patentansprüche

1. Verfahren zum Abscheiden von insbesondere aus mehreren Komponenten bestehenden Halbleiterschichten auf ein oder mehreren Substraten (21), die auf einem Suszeptor (2) aufliegen, der eine von einer Heizeinrichtung (5) auf eine Prozesstemperatur beheizte Wandung einer Prozesskammer (1) ausbildet, wobei durch Strömungskanäle (15, 16; 18) eines Gaseinlassorganes (8) von einem Gasmischsystem (22) bereitgestellte Prozessgase, die eine metallorganische Komponente der II- oder III-Hauptgruppe und ein Hydrid der V- oder VI-Hauptgruppe enthalten, zusammen mit einem Trägergas in die Prozesskammer (1) eingeleitet werden, welches Trägergas die Prozesskammer (1) im Wesentlichen parallel zum Suszeptor durchströmt und durch ein Gasauslassorgan (7) verlässt, wobei sich die Prozessgase zumindest an der Oberfläche des beheizten Substrates (21) pyrolytisch in Zerlegungsprodukte zerlegen und die Zerlegungsprodukte auf der Substratoberfläche und auf der Oberfläche des stromabwärts mit einem Abstand (D) zum stromabwärtigen Rand (2') des Suszeptors (2) angeordneten Gasauslassorganes (7) zumindest bereichsweise eine Beschichtung bildend aufwachsen, wobei ein erster Prozessschritt bei einer ersten Prozesstemperatur durchgeführt wird und danach ohne zwischenzeitiges Reinigen oder Austauschen des mit aufgewachsenen Zerlegungsprodukten belegten Gasauslassorganes (7) ein zweiter Prozessschritt bei einer zweiten Prozesstemperatur durchgeführt wird, welche um mindestens 500°C höher ist als die erste Prozesstemperatur, **dadurch gekennzeichnet, dass** der Abstand (D) groß genug ist, um zu verhindern, dass von der Beschichtung des Gasauslassorganes (7) bei der zweiten Prozesstemperatur abdampfende Zerlegungsprodukte, Fragmente oder Konglomerate davon durch Gegenstromdiffusion oder Rezirkulation zum Substrat (21) gelangen, und dass das Gasauslassorgan (7) während der beiden Prozessschritte derart temperiert wird, dass dessen Oberflächentemperaturen bei beiden Prozessschritten nur um maximal 100°C verschieden voneinander sind.

2. Verfahren nach Anspruch 1, **dadurch gekennzeichnet, dass** in den beiden Prozessschritten unterschiedliche Schichten insbesondere mit einer unterschiedlichen Materialzusammensetzung auf dem Substrat (21) abgeschieden werden.

3. Verfahren nach einem der vorhergehenden Ansprüche, **dadurch gekennzeichnet, dass** der Abstand (D) mindestens der dreifachen Diffusionslänge entspricht.

4. Verfahren nach einem der vorhergehenden Ansprüche, **dadurch gekennzeichnet, dass** das Gasauslassorgan (7) von der Heizeinrichtung (5') aktiv beheizt wird und sich die Oberflächentemperatur bei den beiden Prozessschritten nur so weit ändert, dass sie bei beiden Prozessschritten oberhalb einer Adduktbildungstemperatur liegt.

5. Verfahren nach einem der vorhergehenden Ansprüche, **dadurch gekennzeichnet, dass** der erste Prozessschritt ein Abscheidungsprozess ist und der zweite Prozessschritt ein ggf. nach einem Austausch der Substrate durchgeführter Temper-Schritt ist.

6. Vorrichtung zum Abscheiden von insbesondere aus mehreren Komponenten bestehenden Halbleiterschichten auf ein oder mehreren Substraten (21), mit einem Suszeptor (2), auf dem das Substrat (21) aufliegt und der eine von einer Heizeinrichtung (5) auf eine Prozesstemperatur beheizte Wandung einer Prozesskammer (1) ausbildet, mit einem mittels Gaszuleitungen (27, 28) mit einem Gasmischsystem (22) verbunden Gaseinlassorgan (8), wobei durch Strömungskanäle (15,16,18) des Gaseinlassorganes (8) vom Gasmischsystem (22) bereitgestellte Prozessgase, die eine metallorganische Komponente der II- oder III-Hauptgruppe und ein Hydrid der V- oder VI-Hauptgruppe enthalten, und in Vorratsbehältern (23, 25) des Gasmischsystems (22) bevorratet werden, zusammen mit einem Trägergas in die Prozesskammer (1) einleitbar sind und die Strömungskanäle (15, 16; 18) sowie ein Gasauslassorgan (7), durch welches die Gase die Prozesskammer (1) verlassen, derart in der Prozesskammer (1) angeordnet sind, dass das Trägergas die Prozesskammer (1) im Wesentlichen parallel zum Suszeptor (2) durchströmt, wobei der Suszeptor (2) und das stromabwärts des Suszeptors (2) mit einem Abstand (D) zum stromabwärtigen Rand (2') des Suszeptors angeordnete Gasauslassorgan (7) von der Heizeinrichtung (5) direkt oder indirekt derart aufheizbar sind, dass sich die Prozessgase zumindest an der Oberfläche des Substrates (21) in Zerlegungsprodukten zerlegen und die Zerlegungsprodukten auf den heißen Oberflächen des Substrates (21) und des Gasauslassorganes (7) pyrolytisch zumindest bereichsweise eine Beschichtung bildend aufwachsen, **dadurch gekennzeichnet, dass** der Abstand (D) groß genug ist, um zu Verhindern, dass von der Beschichtung des Gasauslassorganes (7) abdampfende Zerlegungsprodukte, Fragmente oder Konglomerate davon durch Gegenstromdiffusion oder Rezirkulation zum Substrat (21) zu gelangen, und dass das Gasauslassorgan (7) während zweier Prozessschritte mit um mindestens 500°C verschiedenen Prozesstemperaturen derart temperierbar ist, dass dessen Oberflächentemperaturen bei den beiden Prozessschritten nur maximal 100°C verschieden voneinander sind.

7. Vorrichtung nach Anspruch 6, **dadurch gekennzeichnet, dass** der Suszeptor (2) auf einer Stützplatte (13) aufliegt, deren Randbereich über den stromabwärtigen Rand (2') des Suszeptors (2) hinaus bis zum Gasauslassorgan sich erstreckt.

8. Vorrichtung nach Anspruch 6 oder 7, **dadurch gekennzeichnet, dass** die eine Diffusionsbarriere ausbildende Stützplatte (13) aus Quarz besteht und der Suszeptor (2) aus Graphit besteht.

9. Vorrichtung nach Anspruch 7 oder 8, **gekennzeichnet durch** eine unterhalb der Stützplatte (13) angeordnete Platte (14), die ebenfalls aus Quarz besteht.

10. Vorrichtung nach einem der Ansprüche 6 bis 9, **dadurch gekennzeichnet, dass** die Heizeinrichtung (5) von einer oder mehreren unterhalb des Suszeptors (2) und insbesondere unterhalb der Platten (13,14) angeordnete RF-Spirale gebildet ist, wobei eine äußerste Windung (5') das Gasauslassorgan (7) aktiv beheizt.

11. Vorrichtung nach einem der Ansprüche 6 bis 10, **dadurch gekennzeichnet, dass** das Gasauslassorgan (7) die kreisförmige Prozesskammer (1) umgibt und eine Vielzahl von Öffnungen (9) aufweist, durch welche das Trägergas sowie Reaktionsprodukte der Prozessgase in ein Sammelvolumen (10) des Gasauslassorganes (7) gelangen, welches mit einem Austrittskanal (11) mit einer Vakuumpumpe verbunden ist.

12. Vorrichtung nach einem der Ansprüche 6 bis 11, **dadurch gekennzeichnet, dass** die Zuleitungen (27, 28) über zwischengeschaltete Massenflussregler (26) und Ventile mit Vorratsbehältern (23, 24, 25) verbunden sind, die ein Trägergas (24), ein Metallorganikum (23) und ein Hydrid (25) beinhalten.

13. Vorrichtung nach einem der Ansprüche 6 bis 12, **dadurch gekennzeichnet, dass** das Gasauslassorgan (7) vertikal unterhalb des sich in einer Horizontalebene erstreckenden Suszeptors (2) angeordnet ist.

## Claims

1. Method for depositing semiconductor layers consisting in particular of a plurality of components on one or more substrates (21) which are supported on a susceptor (2), the susceptor forming a wall portion of a process chamber (1), said wall portion being heated by a heating device (5) to a process temperature, process gases containing an organometallic component of the II or III main group and a hydride of the V or VI main group and provided by a gas mixing system (22) being introduced together with a carrier gas into the process chamber (1) through flow channels (15, 16; 18) of a gas inlet element (8), which carrier gas flows through the process chamber (1) substantially parallel to the susceptor and leaves through a gas outlet element (7), the process gases decomposing into products of decomposition in a pyrolytic manner at least on the surface of the heated substrate (21) and the decomposition products growing to form a coating at least in certain regions on the substrate surface and on the surface of the gas outlet element (7) that is located downstream at a spacing (D) from the downstream edge (2') of the susceptor, a first process step being carried out at a first process temperature and after that, a second process step being carried out at a second process temperature without intervening cleaning or exchange of the gas outlet element (7) coated by growth of decomposition products, the second process temperature being higher than the first process temperature by at least 500°C, **characterized in that** the spacing (D) is sufficiently great to prevent decomposition products, or fragments or agglomerations of decomposition products, evaporating at the second process temperature from the coating of the gas outlet element (7), from reaching the substrate (21) by reverse flow diffusion or recirculation, and **in that** heating of the gas outlet element (7) is controlled during the two process steps so that its surface temperatures during both process steps differ from one another only by 100°C at a maximum.

2. Method according to Claim 1, **characterized in that** different layers are deposited on the substrate (21) in the two process steps, in particular using a different material composition.

3. Method according to one of the preceding claims, **characterized in that** the spacing (D) corresponds at least to three times the diffusion length.

4. Method according to one of the preceding claims, **characterized in that** the gas outlet element (7) is actively heated by the heating device (5') and the surface temperature during the two process steps only changes to such extent that it lies above an adduct formation temperature for both process steps.

5. Method according to one of the preceding claims, **characterized in that** the first process step is a deposition process and the second process step is a heat treatment step that is carried out optionally after an exchange of the substrates.

6. Apparatus for depositing semiconductor layers consisting in particular of a plurality of components on one or more substrates (21), comprising a susceptor (2), on which the substrate (21) is supported and which forms a wall portion of a process chamber (1), said wall portion being heated by a heating device (5) to a process temperature, comprising a gas inlet element (8) connected to a gas mixing system (22) by means of gas feed lines (27, 28), process gases provided by the gas mixing system (22) being introducible together with a carrier gas into the process chamber (1) through flow channels (15, 16, 18) of the gas inlet element (8), the process gases containing an organometallic component of the II or III main group and a hydride of the V or VI main group and being stored in reservoirs (23, 25) of the gas mixing system (22), the flow channels (15, 16; 18) and the gas outlet element (7) through which the gases leave the process chamber (1) being arranged in the process chamber (1) in such a way that the carrier gas flows through the process chamber (1) substantially parallel to the susceptor (2), the susceptor (2) and the gas outlet element (7) that is located downstream from the susceptor (2) and at a spacing (D) from the downstream edge (2') of the susceptor being heatable directly or indirectly by the heating device (5) in such a way that the process gases decompose into products of decomposition at least on the surface of the substrate (21) and the decomposition products grow to form a coating as least in certain regions, in a pyrolytic manner, on the hot surfaces of the substrate (21) and the gas outlet element (7), **characterized in that** the spacing (D) is sufficiently great to prevent decomposition products, or fragments or agglomerations of decomposition products, evaporating from the coating of the gas outlet element (7), from reaching the substrate (21) by reverse flow diffusion or recirculation, and **in that** heating of the gas outlet element (7) can be controlled during two process steps that have process temperatures that differ by at least 500°C so that its surface temperatures during the two process steps differ from one another only by 100°C at a maximum.

7. Apparatus according to Claim 6, **characterized in that** the susceptor (2) is supported on a support plate (13), the edge region of which extends outwardly beyond the downstream edge (2') of the susceptor (2) as far as the gas outlet element.

8. Apparatus according to Claim 6 or 7, **characterized in that** the support plate (13) that forms a diffusion barrier consists of quartz and the susceptor (2) consists of graphite.

9. Apparatus according to Claim 7 or 8, **characterized by** a plate (14) that is disposed underneath the support plate (13) and likewise consists of quartz.

10. Apparatus according to one of Claims 6 to 9, **characterized in that** the heating device (5) is formed by one or more RF spirals that are located underneath the susceptor (2) and in particular underneath the plates (13, 14), an outermost winding (5') actively heating the gas outlet element (7).

11. Apparatus according to one of Claims 6 to 10, **characterized in that** the gas outlet element (7) encircles the circular process chamber (1) and has a multiplicity of openings (9), through which the carrier gas and reaction products of the process gases reach a collecting volume (10) of the gas outlet element (7), which volume is connected to a vacuum pump by way of a discharge channel (11).

12. Apparatus according to one of Claims 6 to 11, **characterized in that** the feed lines (27, 28) are connected to reservoirs (23, 24, 25) via interposed mass flow regulators (26) and valves, the reservoirs containing a carrier gas (24), an organometallic substance (23) and a hydride (25).

13. Apparatus according to one of Claims 6 to 12, **characterized in that** the gas outlet element (7) is located vertically lower than the susceptor (2) that extends in a horizontal plane.

## Revendications

1. Procédé pour déposer des couches semi-conductrices constituées en particulier de plusieurs éléments, sur un ou plusieurs substrats (21) qui reposent sur un suscepteur (2) formant une paroi d'une chambre de traitement (1) qui est chauffée à une température de traitement par un dispositif de chauffage (5), dans lequel des gaz de traitement préparés par un mélangeur de gaz (22) et comportant un composé organométallique des groupes principaux II ou III et un hydrure des groupes principaux V ou VI, sont introduits ensemble avec un gaz porteur dans la chambre de traitement (1) à travers des canaux (15, 16 ; 18) d'un organe d'introduction de gaz (8) lequel gaz porteur traverse la chambre de traitement (1) de manière sensiblement parallèle au suscepteur et sort de celle-ci par un organe d'évacuation de gaz (7), dans lequel les gaz de traitement se décomposent par pyrolyse en produits de décomposition au moins à la surface du substrat (21) chauffé et les produits de décomposition croissent en formant une couche au moins par zones sur la surface du substrat et sur la surface de l'organe d'évacuation de gaz (7) agencé en aval avec un espacement (D) par rapport au bord aval (2') du suscepteur (2), dans lequel une première étape de traitement est réalisée sous une première température de traitement et ensuite une deuxième étape de traitement est réalisée sous une deuxième température de traitement sans qu'intervienne entre les deux de nettoyage ou de remplacement des organes d'évacuation de gaz (7) revêtu des produits de décomposition qui y ont crû, la deuxième température de traitement étant supérieure d'au moins 500°C à la première température de traitement, **caractérisé en ce que** l'espacement (D) est suffisamment grand pour éviter que des produits de décomposition, des fragments ou des agglomérats de ceux-ci qui s'évaporent de la couche sur l'organe d'évacuation de gaz (7) lors de la deuxième température de traitement, n'atteignent le substrat (21) par diffusion à contre-courant ou recirculation, et **en ce que** la température de l'organe d'évacuation de gaz (7) est contrôlée lors des deux étapes de traitement de manière à ce que ses températures superficielles lors des deux étapes de traitement ne diffèrent l'une de l'autre que de 100°C au maximum.

2. Procédé selon la revendication 1, **caractérisé en ce que** sont déposées sur le substrat (21) des couches différentes, en particulier avec un agrégat de matériaux différents, lors des deux étapes de traitement.

3. Procédé selon l'une des revendications précédentes, **caractérisé en ce que** l'espacement (D) correspond à au moins trois fois la longueur de diffusion.

4. Procédé selon l'une des revendications précédentes, **caractérisé en ce que** l'organe d'évacuation de gaz (7) est activement chauffé par le dispositif de chauffage (5') et **en ce que** la température superficielle ne change pendant les deux étapes de traitement que dans le mesure pour être au-dessus d'une température de formation de produits d'addition lors des deux étapes de traitement.

5. Procédé selon l'une des revendications précédentes, **caractérisé en ce que** la première étape de traitement est un traitement de déposition et la deuxième étape de traitement est un traitement de recuit exécuté le cas échéant après remplacement des substrats.

6. Dispositif pour déposer des couches semi-conductrices constituées en particulier de plusieurs éléments, sur un ou plusieurs substrats (21), comprenant un suscepteur (2) sur lequel repose le substrat (21) et formant une paroi d'une chambre de traitement (1) qui est chauffée à une température de traitement par un dispositif de chauffage (5), un organe d'introduction de gaz (8) relié avec un mélangeur de gaz (22) par des conduits d'alimentation de gaz (27, 28), dans lequel des gaz de traitement qui comportent un composé organométallique des groupes principaux II ou III et un hydrure des groupes principaux V ou VI et qui sont préparés par le mélangeur de gaz (22) et stockés dans des réservoirs de stockage (23, 25) de celui-ci, sont susceptibles d'être introduit ensemble avec un gaz porteur dans la chambre de traitement (1) par des canaux (15, 16 ; 18) de l'organe d'introduction de gaz (8), lesquels canaux (15, 16 ; 18) ainsi qu'un organe d'évacuation de gaz (7) par lequel les gaz quittent la chambre de traitement (1), sont agencés dans la chambre de traitement (1) de manière à ce que le gaz porteur traverse la chambre de traitement (1) de manière sensiblement parallèle au suscepteur (2), dans lequel le suscepteur (2) et l'organe d'évacuation de gaz (7) agencé en aval du suscepteur (2) avec un espacement (D) par rapport au bord aval (2') du suscepteur (2), sont susceptibles d'être chauffés directement ou indirectement par le dispositif de chauffage (5) de manière à ce que les gaz de traitement se décomposent en produits de décomposition au moins à la surface du substrat (21) et que les produits de décomposition croissent en formant une couche par pyrolyse au moins par zones sur les surfaces chaudes du substrat (21) et de l'organe d'évacuation de gaz (7), **caractérisé en ce que** l'espacement (D) est suffisamment grand pour éviter que des produits de décomposition, des fragments ou des agglomérats de ceux-ci qui s'évaporent de la couche sur l'organe d'évacuation de gaz (7) n'atteignent le substrat (21) par diffusion à contre-courant ou recirculation, et **en ce que** lors de deux étapes de traitement avec des températures de traitement qui diffèrent d'au moins 500°C, la température de l'organe d'évacuation de gaz (7) est susceptible d'être contrôlée de manière à ce que ses températures superficielles lors des deux étapes de traitement ne diffèrent l'une de l'autre que de 100°C au maximum.

7. Dispositif selon la revendication 6, **caractérisé en ce que** le suscepteur (2) repose sur une plaque d'appui (13) dont la région de bord s'étend au-delà du bord aval (2') du suscepteur (2) jusqu'à l'organe d'évacuation de gaz.

8. Dispositif selon la revendication 6 ou 7, **caractérisé en ce que** la plaque d'appui (13) qui forme une barrière de diffusion, est réalisée en quartz et **en ce que** le suscepteur (2) est réalisé en graphite.

9. Dispositif selon la revendication 7 ou 8, **caractérisé par** une plaque (14) agencée sous la plaque d'appui (13) laquelle est également réalisée en quartz.

10. Dispositif selon l'une des revendications 6 à 9, **caractérisé en ce que** le dispositif de chauffage (5) est formé par une ou plusieurs bobines RF agencées sous le suscepteur (2) et en particulier sous les plaques (13, 14), dans lequel un enroulement (5') le plus extérieur chauffe activement l'organe d'évacuation de gaz (7).

11. Dispositif selon l'une des revendications 6 à 10, **caractérisé en ce que** l'organe d'évacuation de gaz (7) entoure la chambre de traitement (1) de forme circulaire et présente une pluralité d'ouvertures (9) à travers lesquelles le gaz porteur, ainsi que les produits de réaction des gaz de traitement arrivent dans un volume de collecte (10) de l'organe d'évacuation de gaz (7) lequel est relié à une pompe à vide par un canal d'évacuation (11).

12. Dispositif selon l'une des revendications 6 à 11, **caractérisé en ce que** les conduits d'alimentation (27, 28) sont reliés avec des réservoirs (23, 24, 25) par le biais de régulateurs de débit massique (26) et de vannes, lesquels réservoirs contiennent un gaz porteur (24), un composé organométallique (23) et un hydrure (25).

13. Dispositif selon l'une des revendications 6 à 12, **caractérisé en ce que** l'organe d'évacuation de gaz (7) est agencé verticalement sous le suscepteur (2) lequel s'étend dans un plan horizontal.
